## Europäisches Patentamt
### European Patent Office
### Office européen des brevets

(19)

(11) Publication number: **0 190 372**
**A1**

(12)

# EUROPEAN PATENT APPLICATION

(21) Application number: **85100884.7**

(22) Date of filing: **29.01.85**

(51) Int. Cl.⁴: **H 05 K 13/04**

(43) Date of publication of application:
13.08.86 Bulletin 86/33

(84) Designated Contracting States:
CH DE FR GB LI NL

(71) Applicant: **TEKMA KINOMAT S.p.A.**
**Via E. Fermi, 635**
**I-21042 Caronno Pertusella (Varese)(IT)**

(72) Inventor: **Camardella, Giuseppe**
**Via Miola 1**
**I-21047 Saronno Varese(IT)**

(74) Representative: **Faggioni, Giovanmaria, Dr. et al,**
**Fumero-Studio Consulenza Brevetti Widenmayerstrasse**
**4/I**
**D-8000 München 22(DE)**

(54) Process for the automatic positioning of chips on printed circuits and machine for carrying out the same.

(57) This invention relates to a process for positioning and fixing "chips" onto a printed circuit, in machines of the "pick and place" type, which provides for the use of at least one operating head comprising arms for positioning the single chips, movable along the axis Y-Y of a cartesian plane of orthogonal coordinates and, in correspondence of each operating head, of a carriage for the support of the printed circuit, movable along the axis X-X of the same cartesian plane.

EP 0 190 372 A1

Fig. 2

"PROCESS FOR THE AUTOMATIC POSITIONING OF CHIPS ON PRINTED CIRCUITS AND MACHINE FOR CARRYING OUT THE SAME"

—ooOoo—

As known, the production of electronic circuits is now-a-days carried out with different techniques. One of the most spread techniques, especially for miniatured circuits, consists in using a plate support in the form of a printed circuit, onto which are fixed the single components of the electronic circuit.

Originally, printed circuits were made with a plurality of perforations, forming as many insertion and welding points for the terminals of the circuit components.

With the miniaturing of components, this technique can now-a-days be considered partly overcome. In fact, said components – as resistors, capacitors, transistors, diodes and even integrated circuits – are realized in the form of micro-modules, more commonly known as "chips", of very small dimensions – for instance, of the order of 1.5 x 3.5 mm and having a thickness of a few millimeter tenths – which do not comprise the usual projecting terminals and which are normally fixed on the printed circuits by glueing and subsequent welding.

The positioning, glueing and welding operations of the chips on the printed circuit are at present carried out with fully automated techniques, allowing besides high rhythms of production.

The automatic machines carrying out these operations are in turn based on different working principles. Among these machines, the present invention particularly refers to those which operate the positioning of chips, one by one and with high precision, commonly known as "pick and place" machines. Machines of this type normally comprise several operating heads, in sequence, and each operating head comprises a positioning arm, which is apt to pick up one chip at a time, from a storage unit, and to carry it in a correct position on the printed circuit, this latter being held stationary in a predetermined position facing the operating head. To perform this function, the positioning arm is apt to move along two orthogonal directions X-X and Y-Y, under the control of position control means.

It is evidently understood that a machine of this type is relatively slow. To overcome this drawback it has therefore been proposed to use operating heads, having a plurality of parallel positioning arms - for instance, fifteen arms or more - apt to move only in the direction of the axis Y-Y, always under the control of position control means.

Each printed circuit is actually moved forward in correspondence of a first operating head, it is held there in a fixed set position, whereupon the single positioning arms place a first group of chips onto the printed circuit. This latter is then moved in correspondence of a second operating head, where a second group of chips is positioned; this carries on throughout the successive operating heads, until all the chips are fixed onto the printed circuit. This technique allows to carry out the positioning and fixing of some hundreds of chips, onto a single printed circuit, in minimum amounts of time.

In all the known machines of this type, the printed circuit is moved forward through the successive operating heads along a rectilinear path (which is considered parallel to the axis X-X of a cartesian plane of orthogonal coordinates), for instance by means of a conveyor belt, and it is then locked against fixed stops, in a perfectly set position facing the respective operating head. As said, the single arms for positioning the operating heads are instead moved along trajectories parallel to the axis Y-Y of the same cartesian plane. In this manner, considering the printed circuit to form said cartesian plane, it is evident that - at least in theory - the positioning arms can reach and place the chips in any point of the printed circuit.

In practice, however, there is considerable limitation in the choice of the positions for fixing the chips onto the printed circuit, due to the fact that the single positioning arms have a transversal dimension of their own (namely in the direction of the axis X-X) determined by requirements of mechanical stoutness, taking into account the transport motion which has to be carried out. Generally, the transversal dimension of the positioning arms is of the order of 10-12 mm, and this allows - taking also into account the space required between the arms, to permit motion thereof - a distance between the axes of said arms, in the direction of the axis X-X, of the order of 15 mm. It is thus evident that the single chips cannot be positioned in any point of the printed circuit, but only in any point along the right lines parallel to the axis Y-Y and reciprocally spaced by 15 mm.

As well known to the technicians skilled in the art, this forms a serious limitation, since:

- the pattern of the printed circuit cannot be freely planned, as this limitation has to be taken into account: this of course complicates said circuit even further; and additionally,

- this limitation, as it appears evident, results into a waste of space on the printed circuit, seen that the dimensions of the chips are well below 15 mm.

To overcome this difficulty, it is usually not possible to reduce the transversal dimension of the positioning arms, as - taking into account the long overhanging stroke which said arms have to perform to reach all the points of the printed circuit, and the consequent crosswise deflection to which they may be subjected - the relative position control becomes extremely critical.

In a machine of recent construction, it has also been proposed to deliberately cause a flexure, or rather an appropriately controlled oscillation, of the single arms - to the

0190372

left and/or to the right of the respective motion axis Y-Y - so that, in practice, the end of the arm carrying the chip to be positioned moves to a small extent along the axis X-X. By this arrangement, it is then possible to carry out the positioning of the chips onto strips having a width of a few millimeters, parallel to the axis Y-Y, instead of along simple right lines.

A first drawback to be found in this case is that, due to flexure or oscillation, substantially corresponding to a rotation of the positioning arm about a fulcrum close to its base, the end carrying the chip moves sideways not - as would be desirable - parallely to the axis X-X, but according to a circle arc, so as to produce an oblique positioning of the chip, which is normally not acceptable. In any case, to keep within the tolerance limits, said oscillation should be very limited, whereby the chips positioning strip is anyhow narrow and an unattainable space is left between one strip and the other.

A further drawback also lies in the fact that, in controlling such a transversal oscillation of two side-by-side positioning arms, one should take into account any possible interferences of the respective movements. This difficulty, combined to the above circumstance of the narrow positioning strips, makes it normally impossible to use all the positioning arms of the head, so that a part thereof is left unused, in a locked position.

The object of the present invention is a process allowing to overcome all these known drawbacks in a simple and practical manner, and actually permitting to position the chips in any position of the printed circuit and, at the same time, to obtain a machine with stout and reliable positioning arms.

This result is achieved thanks to the fact that, according to the invention, in correspondence of each operating head the positioning arms are moved, under the control of first position adjustment means, along perfectly rectilinear trajectories, parallel to the axis Y-Y, and the printed circuit is in turn moved, under the control of second position adjustment means, in a direction parallel to the axis X-X.

As can be easily understood, both the first position adjustment means, operating separately on the single positioning arms, and the second position adjustment means, can easily be placed under the control of a computer - of the common type for the numerical control of machine tools - so that the process according to the invention can be carried out easily and with short machine setting up times, allowing on the other hand the highest planning flexibility of the printed circuit pattern.

The object of the present invention is also a machine allowing to carry out the aforedescribed process and comprising, in known manner, at least one belt conveyor to transfer a plurality of printed circuits, in sequence, in correspondence of several operating heads, along a path parallel to the axis X-X of a cartesian plane of orthogonal coordinates, each operating head having a plurality of arms for positioning the chips, moving along the axis Y-Y of said cartesian plane, and comprising furthermore locking means to lock each printed circuit in a perfectly adjusted position facing the head, said machine being characterized in that a support carriage is associated to each operating head, said locking means being fixedly connected to said support carriage, for temporarily holding the printed circuit in correspondence of the operating head, position control means being furthermore associated to said carriage in order to move the same and adjust its position along the axis X-X.

Further characteristics and advantages of the process and machine according to the invention will anyhow be more evident from the following description of a preferred embodiment, illustrated by way of example in the accompanying drawings, in which:

Fig. 1 is a plan view showing a general outline of a machine according to the invention, comprising a plurality of operating heads;

Fig. 2 is a partial, very schematic, plan view of one of the operating heads with the respective positioning arms; and

Fig. 3 is a schematic side view of the same operating head.

As said, a "pick and place" machine of the type according to the present invention, comprises a plurality of operating heads T, positioned in sequence, each of which comprises for instance fifteen positioning arms B. A rail R runs in front of the operating heads and is generally provided with a belt conveyor (known per se in machines of this type and therefore not shown in detail), the single printed circuits C, onto which are to be positioned and glued the chips, being moved forward along said rail. Chip feeders A are furthermore arranged beyond said rail R, in correspondence of each of the operating heads T.

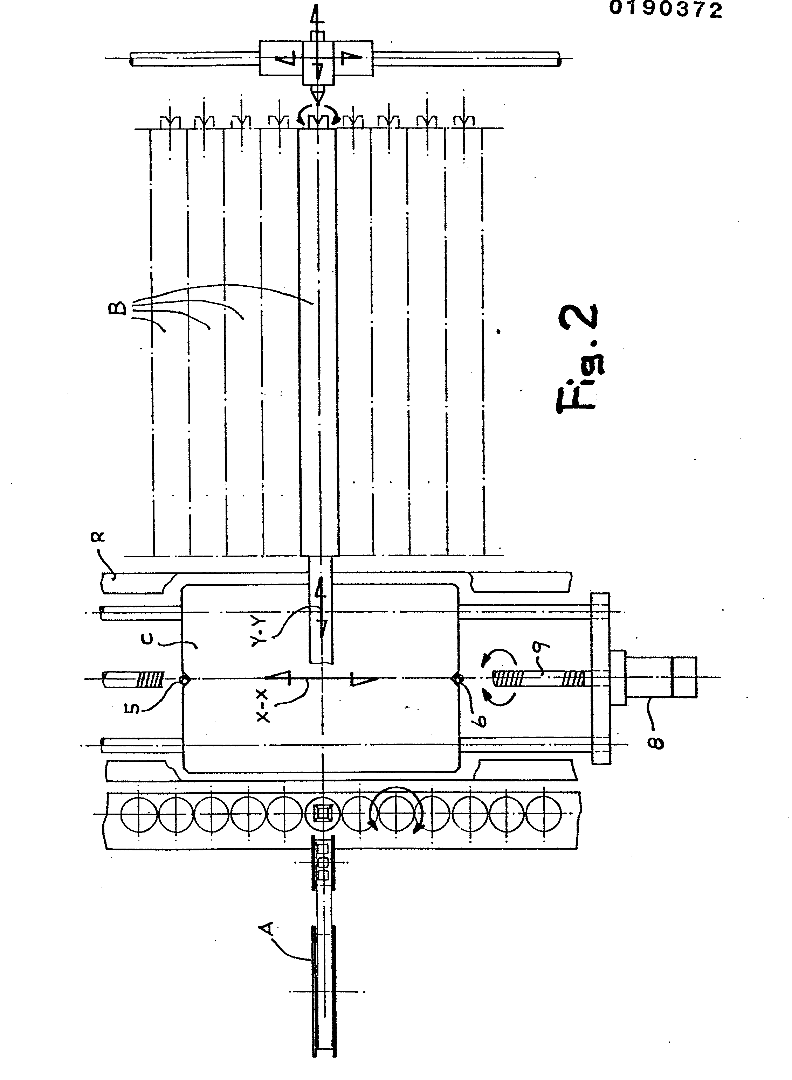

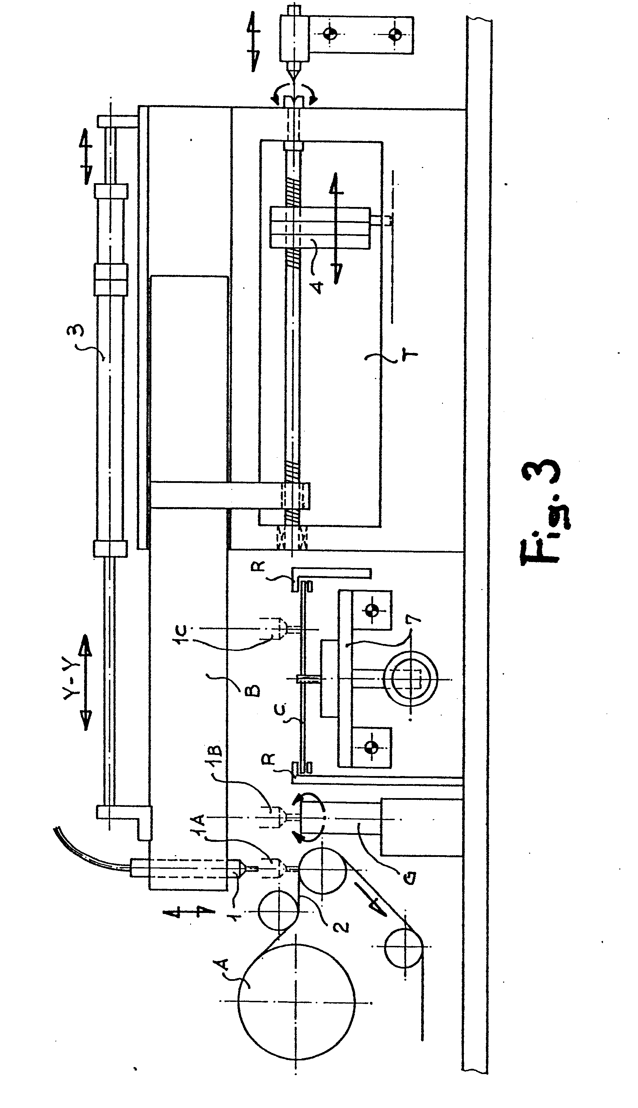

As can be seen from figure 2, each arm B initially performs a movement — from right to left of figure 2 — up to the end-of-stroke, to move in correspondence of the feeding unit A. In this position — shown by continuous lines in figure 3 — the gripping head 1 moves down against the belt 2 conveying the chips (position 1A) and picks up one of the chips. The head 1 normally consists of a nozzle body, which picks up the chips by suction.

Once the chip has been picked up, the arm B moves back as far as carrying the head 1 in correspondence of a positioning unit G (position 1B), which can cause the chip to rotate, when required, by a fixed angle — generally of 90°, 180° or 270° — according to the final position which the chip has to take up on the printed circuit. During this rotation, the chip is always retained, through suction, by the head 1.

Subsequently, the arm B moves back to the final position (shown by 1C in figure 2), perfectly adjusted, to fix the chip on the printed circuit. In this position, the chip is fixed and glued onto the circuit, in a manner known per se.

The motion of the arm B is preferably controlled by a double pneumatic cylinder 3 which, when fully extended, carries the arm B in the end-of-stroke position 1A. A first backward stroke, corresponding to the stroke of one of the cylinders 3, carries the arm B in the position 1B. Lastly, the final backward stroke, to carry the arm B in the perfectly adjusted position 1C, is performed by the second cylinder and determined by the adjustable stop 4. This device for controlling the final stroke of the arm B, by way of the adjustable stop 4, is the object of the previous European Patent application No. 84105967.8, in the name of the same Applicant, and it is therefore not being described in detail.

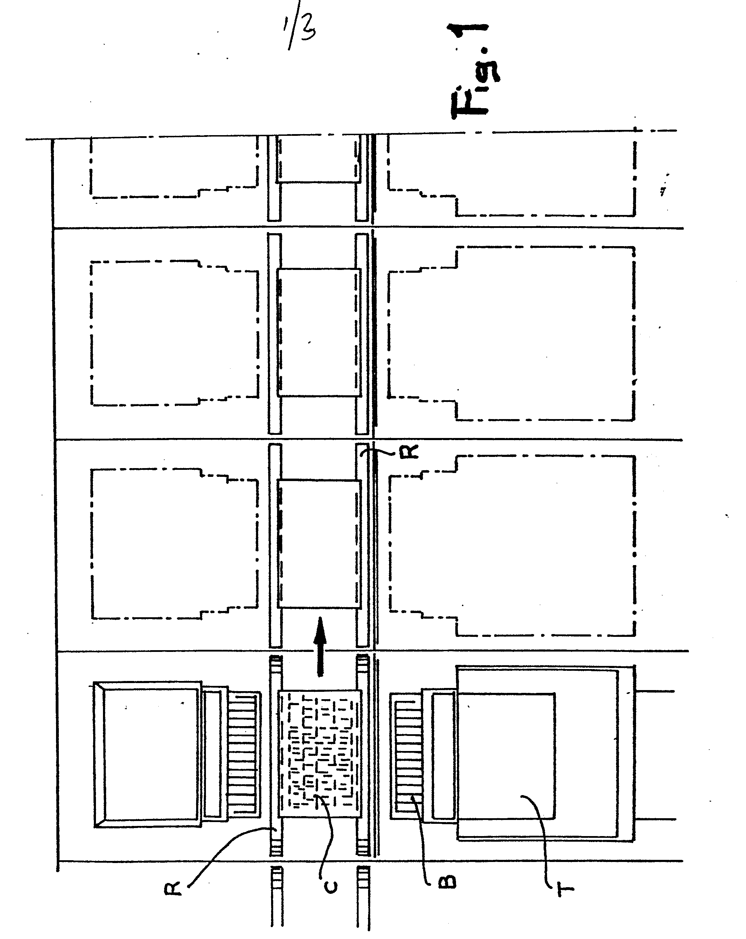

Each of the positioning arms B (figure 1 shows only one with continuous lines and another eight with dashed lines, but obviously this is only a partial illustration, since fifteen or more arms can normally be provided) performs the motion to pick up the chip from the respective feeder A (figure 1 shows only one, but evidently a feeder is used for each arm), sets said chip in correspondence of the unit G, and positions the chip onto the printed circuit C - in the manner described hereabove - under the control of a computer, with a technique commonly adopted in the numerical control of machine tools.

To lock the printed circuit in a perfectly set position, the present invention provides for a pair of locking means 5, 6, for example in the form of pins, fixedly connected to a carriage 7 (figures 1 and 2), which is mounted to move parallely to the rail R, i.e. perpendicularly to the direction of motion of the arms B. The motion of the carriage 7 is controlled by position control means, for instance by a stepping motor 8, which controls the rotation of a worm screw 9, engaging with a nut (not shown) fixed on the carriage 7.

Also the motion of the motor 8, i.e. of the carriage 7, is placed under the control of the aforementioned computer which controls the movement of the arms B, so that a perfect synchronization of the two movements can be obtained.

Operation takes place as follows: the carriage 7 is initially in position zero and the arms B are withdrawn in a rest position. A printed circuit C moves forward along the rail R, drawn by the respective conveyor. At this stage, only the locking pin 5 is in a lifted position, on the trajectory of the printed circuit C, so that this latter is stopped in its forward motion by said pin 5. Soon after, also the locking pin 6 is lifted, to lock firmly and reliably the printed circuit C onto the carriage 7.

At this point, the arms B perform their forward stroke – in the manner heretofore described – in order to pick up the chips, and subsequently perform their adjusted backward stroke, in order to position and fix the chips onto the printed circuit C. If allowed by the planned pattern of the printed circuit, all the arms B operate simultaneously to position an equal number of chips; however, this does not normally take place. It instead happens more frequently that only some chips, for instance four or five, can be fixed while keeping the printed circuit C in position zero. Once a first group of chips has been fixed, the printed circuit C is moved along the axis X-X by an exactly adjusted extent, whereupon the fixing of a second group of chips is carried out. One proceeds in this manner, moving each time the printed circuit by the extent required, by means of the carriage 7 and motor 8, up to positioning all the chips carried by all the arms B of the head T.

As can be easily understood, thanks to this movement of the printed circuit, along the axis X-X, combined with the movement of the arms B in the direction of the axis Y-Y, it is possible to

0190372

reach any position of the printed circuit, without any kind of limitation, in order to fix thereon the pre-established chips. This hence permits the highest freedom of pattern planning of the printed circuit, without taking into consideration any limitations determined by the operating capacities of the machine, as it happened up-to-date.

It is anyhow understood that the invention is not limited to the particular embodiment described and illustrated, which is besides in part very schematic, but that many constructive variants can be obtained by a technician skilled in the art, all falling however within the protection scope of the invention itself.

CLAIMS

1) Process for positioning and fixing miniatured electronic components, or chips, onto a printed circuit, in an operating machine of the "pick and place" type, having at least one operating head comprising a plurality of arms for positioning the single chips, characterized in that said positioning arms are moved, under the control of first position adjustment means, along perfectly rectilinear trajectories, parallel to the axis Y-Y of a plane of cartesian coordinates, and the printed circuit is in turn moved, under the control of second position adjustment means, in a direction parallel to the axis X-X of the same plane.

2) Process as in claim 1), wherein said cartesian coordinates are at right angles and the axis X-X coincides with the main axis along which the printed circuits are moved forward through the operating machine.

3) Process as in claim 1), wherein the printed circuit is moved by steps, at each step only one part of the chips carried by the positioning arms being fixed on said circuit.

4) Machine for carrying out the process as in claims 1), 2) or 3), of the type comprising at least one belt conveyor to move forward a plurality of printed circuits, in sequence, in correspondence of several operating heads, along a path X-X, each of said heads comprising a plurality of arms for positioning the chips, moving along an axis Y-Y transversal to the axis X-X, and locking means to temporarily lock each printed circuit in a perfectly adjusted position facing each operating head, characterized in that, a support carriage is associated to each operating head, said locking means being fixedly connected to said support carriage, for temporarily holding the printed circuit in correspondence of the operating head, and in that, position control means are furthermoreassociated to said carriage in order to move the same and adjust its position along the axis X-X.

5) Machine as in claim 4), wherein said locking means to lock each printed circuit consist of a pair of pins projecting upwardly from said support carriage and apt to be separately inserted on the trajectory of the printed circuit, in order to lock the same on opposite sides.

6) Machine as in claims 4) or 5), wherein the position control of the printed circuit support carriage and, respectively, of the positioning arms, is operated by means of a centralized computer.

Fig.1

0190372

Fig. 2

Fig. 3

0190372

## DOCUMENTS CONSIDERED TO BE RELEVANT

| Category | Citation of document with indication, where appropriate, of relevant passages | Relevant to claim | CLASSIFICATION OF THE APPLICATION (Int Cl.4) |
|---|---|---|---|
| X | US-A-4 346 514 (YOSHIAKI MAKIZAWA) * Column 5, lines 54-63; figure 12 * | 1-3 | H 05 K 13/04 |
| Y | | 4-6 | |
| Y | EP-A-0 016 368 (MATSUSHITA) * Page 8, line 13 - page 9, lines 24; figure 4 * | 4 | |
| Y | FR-A-2 476 963 (PHILIPS) * Page 4, lines 16-22; figure 1 * | 5 | |
| Y | GB-A-2 105 224 (USM CORP.) * Page 2, lines 42-44; page 3, lines 57-117 * | 6 | TECHNICAL FIELDS SEARCHED (Int. Cl.4) |
| X | EP-A-0 092 292 (PHILIPS) * Page 7, lines 24-29; figures 1,2 * | 1,2 | H 05 K 13/00 |

The present search report has been drawn up for all claims

| Place of search | Date of completion of the search | Examiner |
|---|---|---|
| THE HAGUE | 22-10-1985 | TIELEMANS H.L.A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503. 03.82